# EUROPEAN PATENT APPLICATION

(11) **EP 3 643 810 A1**
(43) Date of publication of application: **29.04.2020**
(21) Application number: 18820641.1
(22) Date of filing: 04.06.2018
(51) Int. Cl.: C23C 28/00, C23C 14/06, C23C 14/02, C23C 14/34, C23C 16/30, C23C 16/50, F02M 61/18

(54) **BALL AND VALVE SEAT FOR FUEL INJECTOR, AND METHOD FOR COATING SAME**

(30) Priority: 23.06.2017 KR 20170079894; 01.06.2018 KR 20180063566
(71) Applicant: Hyundai Kefico Corporation, Gyeonggi-do 15849 (KR)
(72) Inventor: CHA, Sung Chul, Seoul 04196 (KR); PARK, Heon Joon, Gunpo-si Gyeonggi-do 15869 (KR); PARK, Joon Hee, Incheon 22126 (KR); HAN, Hye Seong, Ansan-si Gyeonggi-do 15337 (KR)
(74) Representative: Zinkler, Franz
(86) International application number: PCT/KR2018/006336
(87) International publication number: WO 2018/236071

(57) **Abstract**

The present disclosure relates to a ball and a valve seat for a fuel injector, in which an SiO-DLC functional layer having low friction properties is formed as an outermost layer in order to reduce a friction coefficient, a Mo-based material is applied to a bonding layer and a supporting layer for bonding the SiO-DLC functional layer to a base material and supporting the same to improve the heat resistance thereof, and only Mo particles of a pure ion state are deposited so as to form the bonding layer and the support layer, such that adhesive force and bonding force are increased to thus improve durability; and to a method for coating the same.

## Description

### [Technical Field]

The present disclosure relates to a ball and a valve seat for a fuel injector, and a method for coating the same, and more particularly, to a coating structure of a ball and a valve seat on which a coating material is stacked for reducing frictional resistance, and increasing coating hardness and durability life and a method for coating the same.

### [Background Art]

A fuel injector for a vehicle is one of the key components which serve to provide fuel to an engine in a timely manner according to the stroke of the engine.

In this regard, the components of the fuel injector, particularly, as sliding components, a ball and a valve seat are becoming smaller, but due to exposure to higher and repetitive loads and stresses, there occurs the phenomenon in that the lifespan thereof is rapidly lowered due to thermal shock, abrasion, and the like.

As a method for improving the abrasion resistance of such sliding components, Korean Patent Laid-Open Publication No. 10-2014-0038084 discloses a configuration of a coating material which forms a Cr or Ti bonding layer on a base material of a sliding component, forms a CrN or WC support layer on the surface of the bonding layer, and forms a SiO-DLC functional layer on the surface of the support layer, thereby improving the abrasion resistance and heat resistance of the sliding component.

However, according to the configuration disclosed in the document, the SiO-DLC functional layer may be provided on the outermost layer, thereby improving the frictional resistance performance, but there is a problem in that since the Cr, Ti or W-based material may not obtain sufficient heat resistance performance and interlayer bonding force, it is not suitable to be applied in high temperature environment and high vibration environment such as a ball and a valve seat.

Meanwhile, Japanese Patent Laid-Open Publication No. 1994-25826 discloses a configuration of a sliding member to which a Mo-based material is applied instead of a Cr, Ti or W-based material as a coating material.

This document discloses an ion plating type physical vapor deposition method which deposits Mo ions evaporated by using a high energy beam on a base material to form a Mo film in connection with a method of depositing the Mo-based material.

However, the deposition method disclosed in the document has a problem in that there is a very high possibility of causing the phenomenon in which non-ionic particles having a relatively large diameter are deposited together on the base material in addition to the Mo ion particles evaporated from the Mo target by the high energy beam to cause the non-uniformity of the deposited particles, thereby degrading the roughness of the coating film and degrading the bonding force to the base material to remarkably and entirely lower the durability of the coating film.

### [DISCLOSURE]

### [Technical Problem]

The present disclosure is intended to solve the aforementioned problem of the related art, and an object of the present disclosure is to provide a ball and a valve seat for a fuel injector, and a method for coating the same, which form a SiO-DLC functional layer having a low friction characteristic on an outermost layer in order to reduce a friction coefficient, bond the SiO-DLC functional layer to a base material, and apply a Mo-based material to a bonding layer and a support layer for supporting the above, thereby improving the heat resistance, and configure only Mo particles of pure ionic states to be deposited to form the bonding layer and the support layer, thereby increasing the adhesive force and the bonding force to improve durability.

### [Technical Solution]

For achieving the object, the present disclosure provides a ball and a valve seat for a fuel injector on which a coating material having a multilayer structure is stacked on the surface of a base material, in which the coating material includes a Mo bonding layer stacked on the surface of the base material, a MoN support layer stacked on the outer surface of the Mo bonding layer, and a SiO-DLC functional layer stacked on the outer surface of the MoN support layer, and the Mo bonding layer and the MoN support layer are stacked by a physical vapor deposition method, and the SiO-DLC functional layer is stacked by a chemical vapor deposition method.

In addition, the Mo bonding layer is formed by radiating a laser to a Mo target in a vacuum atmosphere to cause an arc and depositing evaporated Mo ions on the base material.

In addition, the MoN support layer is formed by depositing MoN particles, which are formed by reacting Mo ions separated from the Mo target through the laser radiation with N ions separated from N2 gas injected as an activated gas, on the outer surface of the Mo bonding layer in a state where the Mo bonding layer is completely stacked.

In addition, non-ionic particles in addition to the Mo ions are generated by radiating the laser to the Mo target, and the non-ionic particles are collected through an electromagnetic filter, thereby preventing the non-ionic particles from being stacked on the base material or the Mo bonding layer.

In addition, the chemical vapor deposition method includes a PACVD method using carbonization gas and Hexamethyl Disiloxane (HMDSO) gas.

In addition, before the Mo bonding layer is stacked, Ar ions in a plasma state are collided with the surface of the base material, thereby cleaning the surface of the base material.

Meanwhile, the present disclosure provides a coating method of stacking a coating material having a multilayer structure on the surface of a base material of a ball and a valve seat for a fuel injector, the coating method including forming a Mo bonding layer which stacks a Mo bonding layer on the outer circumferential surface of the base material by a physical vapor deposition method, forming a MoN support layer which stacks a MoN support layer on the outer surface of the Mo bonding layer by a physical vapor deposition method, and forming a SiO-DLC functional layer which stacks a SiO-DLC functional layer on the outer surface of the MoN support layer by a chemical vapor deposition layer.

In addition, the forming of the Mo bonding layer includes generating Mo ions which generates evaporated Mo ions by radiating a laser to a Mo target in a vacuum atmosphere to cause an arc, transporting the Mo ions which transports the Mo ions to the surface of the base material, and depositing the Mo ions which deposits the transported Mo ions on the surface of the base material.

In addition, the forming of the MoN support layer includes forming MoN particles which forms MoN particles by reacting the Mo ions separated from the Mo target through the laser radiation with N ions separated from N2 gas injected as an activated gas in a state where the Mo bonding layer is completely stacked, and depositing the MoN particles which deposits the MoN particles on the outer surface of the Mo bonding layer.

In addition, non-ionic particles in addition to the Mo ions are generated in the generating of the Mo ions, and the non-ionic particles are collected through an electromagnetic filter, thereby preventing the non-ionic particles from being stacked on the base material or the Mo bonding layer.

In addition, the chemical vapor deposition method includes a PACVD method using carbonization gas and Hexamethyl Disiloxane (HMDSO) gas.

In addition, the coating method further includes forming vacuum which maintains the internal atmosphere of the reaction chamber as a vacuum state, in a state where the ball and the valve seat are disposed inside a reaction chamber, forming plasma which forms a plasma state where Ar ions are generated by injecting Ar gas into the reaction chamber and increasing the temperature of the reaction chamber, and cleaning the surface of the base material by colliding the Ar ions with the surface of the base material of the ball and the valve seat.

### [Advantageous Effects]

The ball and the valve seat for the fuel injector and the method for coating the same according to the present disclosure may form the SiO-DLC functional layer having the low friction characteristic on the outermost layer in order to reduce the friction coefficient, bond the SiO-DLC functional layer to the base material, and apply the Mo-based material to the bonding layer and the support layer for supporting the above, thereby improving the heat resistance, and may configure only Mo particles of the pure ionic states to be deposited to form the bonding layer and the support layer, thereby increasing the adhesive force and the bonding force to improve durability.

### [Description of Drawings]

FIG. 1 is a partially enlarged diagram of a fuel injector having a ball and a valve seat according to the present disclosure.
FIG. 2 is a schematic diagram illustrating the section of the ball and the valve seat on which a coating material deposited according to an embodiment of the present disclosure is stacked.
FIG. 3 is a picture of a scanning electron microscope (SEM) of the coating material deposited according to an embodiment of the present disclosure.
FIG. 4 is a schematic diagram of a coating apparatus for forming the coating material according to the present disclosure.
FIG. 5 is a flowchart for explaining a coating method according to an embodiment of the present disclosure.

### [Best Mode]

Hereinafter, a configuration of a ball and a valve seat for a fuel injector, and a method for coating the same according to the present disclosure will be described in detail with reference to the accompanying drawings.

Various changes and various embodiments may be made in the present disclosure, such that specific embodiments are illustrated in the drawings and described in detail in the specification. It should be understood, however, that it is not intended to limit the present disclosure to the particular disclosed forms, but includes all modifications, equivalents, and alternatives falling within the sprit and technical scope of the present disclosure.

In describing the present disclosure, the terms "first," "second," and the like may be used to illustrate various components, but the components should not be limited by the terms. The terms are used to differentiate one element from another. For example, a first component may be referred to as a second component, and similarly, the second component may also be referred to as the first component without departing from the scope of the present disclosure.

The terms "and/or" includes a combination of a plurality of related listed items or any of a plurality of related listed items.

When a component is referred to as being "connected" or "coupled" to another component, it may be directly connected or coupled to another component, but it may be understood that other components may be present therebetween. On the other hand, when a component is referred to as being "directly connected" or "directly coupled" to another component, it may be understood that there are no other components therebetween.

The terminology used herein is merely for the purpose of describing particular embodiments, and is not intended to limit the present disclosure. The singular forms used herein may include plural forms, unless the phrases clearly indicate the opposite.

In the present application, it may be understood that the term "comprising", "having", or the like specifies the presence of the characteristic, integer, step, operation, component, part, or a combination thereof described in the specification, and does not exclude the presence or addition possibility of one or more other characteristics, integers, steps, operations, components, parts or combinations thereof in advance.

Unless defined otherwise, all terms including technical terms and scientific terms used herein have the same meaning as commonly understood by those skilled in the art to which the present disclosure pertains. Terms, such as those defined in commonly used are interpreted to have a meaning consistent with the related technical literature and the presently disclosed contents, and are not interpreted in an ideal or very formal sense unless defined clearly in the present application.

In addition, the following embodiments are provided to more fully describe the present disclosure to those skilled in the art, and the shape and size of the elements in the drawings may be exaggerated for clarity.

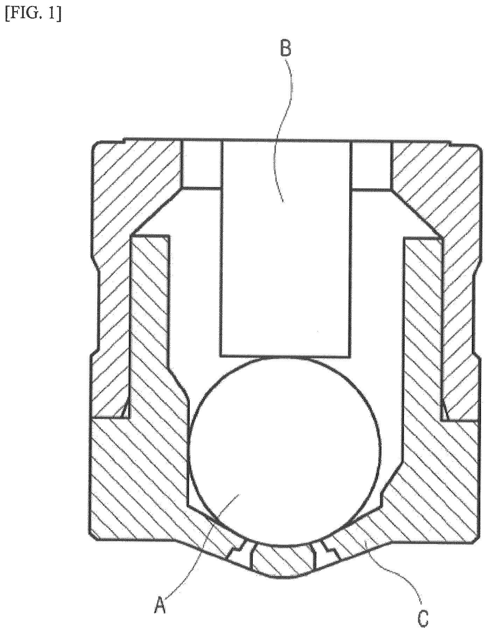

FIG. 1 is a partially enlarged diagram of a fuel injector to which a ball and a valve seat according to the present disclosure are applied.

Referring to FIG. 1, a fuel injector includes a housing accommodating a needle therein, a valve seat (C) formed at the lower end of the housing, and a ball (A) disposed between the valve seat (C) and the needle (B). The valve seat (C) has a valve seat surface on which the ball (A) is seated, and the valve seat (C) is provided with a nozzle penetrating in the fuel injection direction.

The needle (B) opens and closes the nozzle formed on the valve seat (C) while moving the ball (A) vertically by the operations of a magnetic coil and a return spring not illustrated.

Although FIG. 1 illustrates the ball (A) having a spherical shape, the present disclosure is not limited thereto, and in addition, may apply valve bodies having various shapes without limitation, and these will all be considered to fall within the scope of the present disclosure. For convenience, the following description will be made based on an embodiment of the ball (A) having a spherical shape.

Since the fuel injector, particularly, a direct injection type fuel injector, directly injects fuel into a cylinder, the ball (A) and the valve seat (C) are exposed to high temperature and high pressure states, and there is a high possibility of causing the phenomenon such as nozzle clogging due to combustion byproducts such as carbon monoxide and soot.

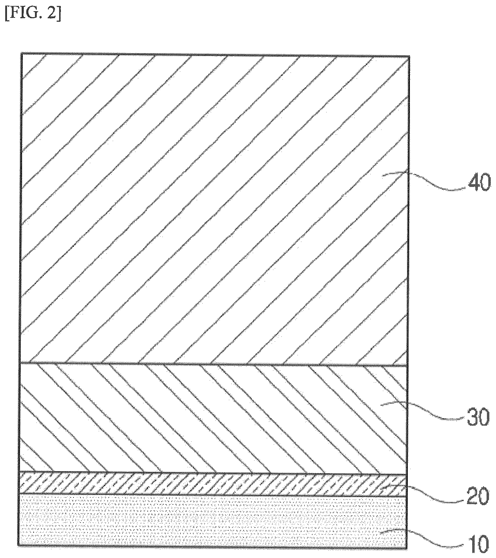

As described above, since the ball (A) and the valve seat (C) are exposed to the high temperature and high pressure states, and frictional resistance is largely generated due to the combustion by-products, thereby being easily broken, as illustrated in FIG. 2, the present disclosure is configured to stack a coating material of a multilayer structure on a base material 10 of the ball (A) and the valve seat (C), thereby reducing the frictional resistance, increasing the durability, and increasing heat resistance.

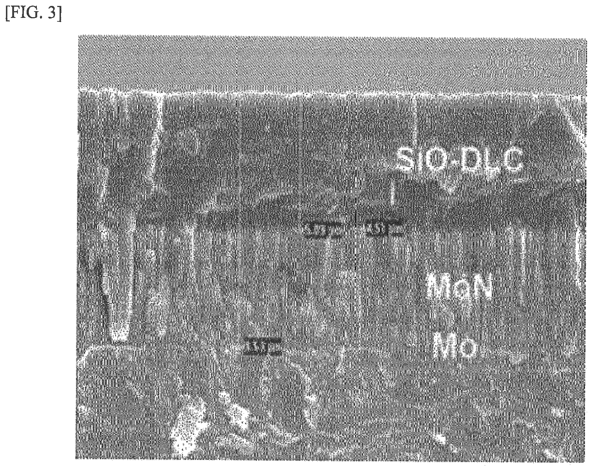

Referring to FIGS. 2 and 3, the coating material according to an embodiment of the present disclosure includes a Mo bonding layer 20 stacked on the surface of the base material 10 of the ball and the valve seat, a MoN support layer 30 stacked on the outer surface of the Mo bonding layer 20, and a SiO-DLC functional layer 40 stacked on the outer surface of the MoN support layer 30.

At this time, the Mo bonding layer 20 and the MoN support layer 30 are stacked by a physical vapor deposition method, preferably, a Filtered Laser Arc Deposition (FLAD) method, and the SiO-DLC functional layer 40 is stacked by a chemical vapor deposition method, preferably, a Plasma-Assisted Chemical Vapor Deposition (PACVD) method using a carbonization gas and Hexamethyl Disiloxane (HMDSO) gas.

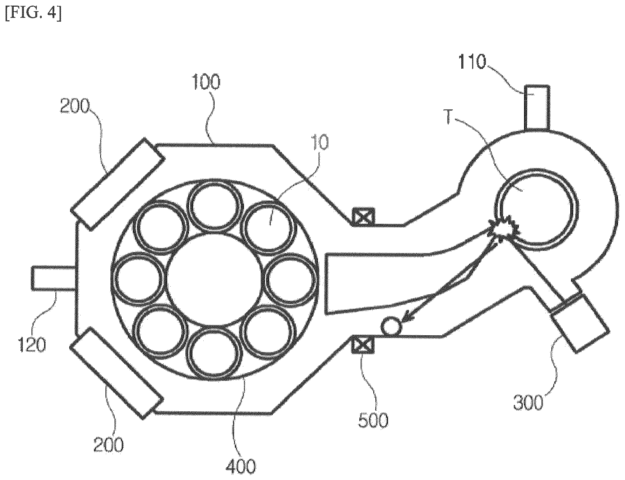

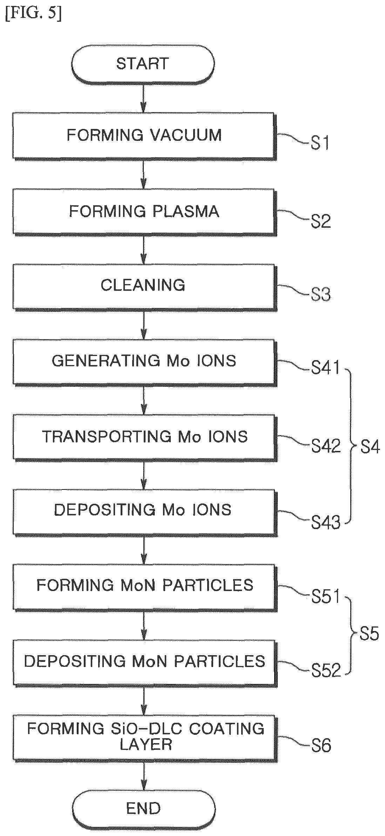

Detailed steps of stacking these Mo bonding layer 20, the MoN support layer 30, and the SiO-DLC functional layer 40 will be described later with reference to FIGS. 4 and 5.

The Mo bonding layer 20 performs a function of bonding the base material 10 of the ball and the valve seat and the MoN support layer 30, and may be formed in a thickness of the range of 0.01 to 0.5*µ*m, preferably, 0.1*µ*m, but is not limited to thereto.

If the thickness of the Mo bonding layer 20 is smaller than 0.01*µ*m, there may occur a problem in that the bonding force is lowered, thereby lowering the durability; if it exceeds 0.5*µ*m, thereby may occur a problem in that a coating time is 8 hours or more; and there may occur a problem in that the hardness balance due to the thick film within the coating material is lost, thereby lowering the durability.

The MoN support layer 30 serves to support the Mo bonding layer 20 and the SiO-DLC functional layer 40, and may be formed in a thickness of a range of 0.1 to 5*µ*m, preferably, 0.5*µ*m, but is not limited thereto.

If the thickness of the MoN support layer 30 is smaller than 0.1*µ*m, the interlayer hardness balance is lost due to the lack of the thickness of the support layer, and there occur a problem of lowering the durability due to the loss of the interlayer hardness balance, a problem of locally losing the thickness, and a problem of causing abrasion mark (abrasion initiation point activity). In addition, if the thickness of the MoN support layer 30 exceeds 5*µ*m, there may occur a problem in that the coating time is increased (it takes 8 hours or more) and a problem in that by adversely affecting the SiO-DLC coating, a columnar structure (brittle structure) is formed, thereby increasing residual stress in the layer.

The SiO-DLC functional layer 40 corresponds to the outermost layer of the coating material according to the present disclosure, and serves as a functional layer having low friction, abrasion resistance, and heat resistance.

The thickness of the SiO-DLC functional layer 40 is 0.1 to 10*µ*m, preferably, 1.4*µ*m, but is not limited thereto.

If the thickness of the SiO-DLC functional layer 40 is smaller than 0.1*µ*m, there occurs a problem in that the abrasion is increased and the friction coefficient is increased by the insufficient thickness of the functional layer, thereby lowering the durability, and if the thickness of the SiO-DLC functional layer 40 exceeds 10*µ*m, there may occur problems of increasing the coating time (it takes 8 hours or more) and increasing the costs and a problem of increasing the residual stress in the layer.

As described above, the present disclosure may apply the Mo material as the bonding layer and the support layer, and apply the SiO-DLC as the functional layer of the outermost layer, thereby simultaneously securing sufficient heat resistance performance, abrasion resistance performance, and durability performance as the coating material of the ball and the valve seat for the fuel injector as compared to the case of applying the Cr, Ti, or W-based material conventionally.

Hereinafter, referring to FIGS. 4 and 5, a coating method and a coating apparatus of the ball and the valve seat for the fuel injector according to the present disclosure will be described in detail.

First, the coating material may be formed on the base material 10 of the ball and the valve seat for the vehicle according to the present disclosure by using the coating apparatus illustrated in FIG. 4.

Referring to FIG. 4, the illustrated coating apparatus is configured to include a reaction chamber 100, a Mo target (T) fixed inside the reaction chamber 100, a gas inlet configured to inject a process gas into the reaction chamber 100, a gas outlet 120 configured to discharge the residual process gas, a bias electrode 200, a laser generator 300 configured to radiate the laser to the Mo target (T), a turn table 400 configured to support the base material 10 of the ball and the valve seat, an electromagnetic filter 500 configured to collect the non-ionic particles separated from the Mo target (T), and the like.

The reaction chamber 100 serves to form a predetermined coating condition (temperature and pressure) therein by separating the inner space from the outer space.

A pair of the bias electrodes 200 is provided to serve to form a predetermined bias voltage difference to accelerate Ar ions to collide with the surface of the base material in order to clean the surface of the base material 10 as described later. The bias electrode 200 is connected to a bias power source not illustrated, and as described later, the bias voltage between the pair of the bias electrodes 200 is kept in a range of 200 to 400V.

The laser generator 300 serves to radiate a laser to the Mo target (T) to cause an arc, and evaporate the surface of the Mo target (T) to generate the Mo ions in a gaseous state from the Mo target (T).

That is, the present disclosure uses the laser generator to deposit the Mo ions and the MoN particles through a physical vapor deposition method, preferably, through a laser arc deposition method, as described later.

The laser generator 300 may be applied to the present disclosure without limitation as long as the laser generator 300 has an output of the level capable of generating the Mo ions in the gaseous state from the Mo target (T).

Meanwhile, the electromagnetic filter 500 is a means configured to collect the non-ionic Mo particles in addition to the Mo ions separated from the Mo target (T) by the laser generator 300, and is a means configured to implement a Filtered Laser Arc Deposition (FLAD) added with the electromagnetic filtering in addition to the aforementioned Laser Arc Deposition method.

That is, when the laser is radiated to the Mo target (T) through the laser generator 300 to generate an arc, a large number of non-ionic Mo particles having relatively larger diameters and non-uniform diameters in addition to the evaporated Mo ions in the gaseous state are formed.

If such non-ionic Mo particles are deposited on the base material 10 together with the Mo ions, there is a high possibility of causing a problem in that the deposition surface becomes non-uniform, thereby degrading the surface roughness of the deposition layer and lowering the adhesive force of the deposition layer.

Accordingly, the present disclosure is configured to form the Mo bonding layer and the MoN support layer through the FLAD method in which the non-ionic Mo particles are collected through the electromagnetic filter 500 in order to deposit only pure Mo ions separated from the Mo target (T) on the base material.

As illustrated, the electromagnetic filter 500 is disposed on the moving path of the Mo ions between the Mo target (T) and the turn table 400.

Meanwhile, although not illustrated, the interior of the reaction chamber 100 is provided with a thermostat adjacent to the turn table 400, thereby increasing the internal temperature of the reaction chamber 100 to 600III to the maximum.

Hereinafter, the coating method of the ball and the valve seat for the fuel injector according to the present disclosure will be described step by step with reference to FIG. 5.

First, the base material 10 of the ball and the valve seat is disposed on the turn table 400 inside the reaction chamber 100, and the internal atmosphere of the reaction chamber 100 is formed and kept in a vacuum state (S1).

Next, Ar gases are supplied as the process gas through the gas inlet 110, and a plasma state formed with Ar ions is formed by increasing the temperature by using the thermostat (S2).

Preferably, the interior of the reaction chamber 100 is kept at 80III by using the thermostat.

Thereafter, a bias voltage is applied to the bias electrode 200, and the Ar ions are accelerated to collide with the surface of the base material of the ball and the valve seat, thereby cleaning the surface of the base material of the ball and the valve seat (S3).

This is to increase the adhesive force between the coating material and the base material by first performing an etching process for removing an oxide layer and impurities naturally formed on the surface of the base material of the ball and the valve seat.

In addition, in this case, the bias voltage may be kept in a range of 200 to 400V. If the bias voltage is smaller than 200V, the acceleration voltage of the Ar ions is reduced, thereby lowering the hardness of the coating material, and if the bias voltage exceeds 400V, there may occur a problem in that the lattice arrangement becomes irregular, thereby lowering the adhesive force.

After cleaning the base material of the ball and the valve seat by the Ar ions, the coating method proceeds to the forming of the Mo bonding layer (S3) which forms the Mo bonding layer by laminating the Mo ions on the surface of the base material through the physical vapor deposition method, preferably, through the aforementioned FLAD method.

Specifically, the forming of the Mo bonding layer (S3) may be classified into generating the Mo ions (S41) which generates evaporated Mo ions by radiating a laser to the Mo target in a vacuum atmosphere formed in the vacuum chamber 100 to cause an arc, transporting the Mo ions (S42) which transports the generated Mo ions to the surface of the base material disposed on the turn table 400, and depositing the Mo ions (S43) which deposits the transported Mo ions on the surface of the base material.

Next, it proceeds to forming the MoN support layer (S5) which stacks the MoN support layer on the outer surface of the Mo bonding layer formed in the forming of the Mo bonding layer (S3) through the physical vapor deposition method, preferably, the laser arc deposition method.

Specifically, the forming of the MoN support layer (S5) may be classified into forming the MoN particles (S51) by reacting the Mo ions separated from the Mo target through the laser radiation and N ions separated from N2 gases injected as an activated gas through the gas inlet 110 in a state where the Mo bonding layer 20 is completely stacked, and depositing the MoN particles (S52) which deposits the formed MoN particles on the outer surface of the Mo bonding layer 20.

In this case, the non-ionic particles generated in the generating of the Mo ions (S41) are collected through the electromagnetic filter as described above, thereby preventing the non-ionic particles from being stacked on the base material or the Mo bonding layer.

Next, it proceeds to forming the SiO-DLC functional layer (S6) which stacks the SiO-DLC functional layer 40 on the outer surface of the MoN support layer 30 through the chemical vapor deposition method, preferably, the PACVD method.

Specifically, the SiO-DLC functional layer 40 is formed by injecting carbonization gas (C_{X}H_{Y}) and Hexamethyl Disiloxane (HMDSO) gas, which are process gases, into the reaction chamber 100 through the gas inlet 110, thereby finally completing the formation of the coating material according to the present disclosure.

The DLC layer is to deposit the coating film on the surface by generating plasma in a vacuum state by using the gas of carbon component, and form the carbon film having a diamond-like structure on the surface thereof, and the present disclosure is configured so that the SiO-DLC functional layer 40 is formed through the method of injecting the HMDSO gas while injecting the carbonization gas into the reaction chamber 100 in order to form the DLC layer.

In this case, it is preferable that the carbonization gas is, for example, methane (CH₄) gas and ethane gas (C₂H₆), but the present disclosure is not limited thereto.

Hereinafter, the results of the durability evaluation comparison and the physical property evaluation comparison for the Embodiment manufactured by applying the coating method according to the present disclosure and the Comparative Examples manufactured according to the related art will be described.

### Embodiment

A plasma state was created by using the Ar gases in the state where the interior of the reaction chamber 100 was a vacuum, and the interior of the reaction chamber 100 was heated to 80III to activate the surface of the base material 10 made of SUS400C stainless iron material, and then a bias voltage of 300 V was applied so that the Ar ions collided with the surface, thereby cleaning the surface of the base material.

Thereafter, the Mo bonding layer was stacked in a thickness of 0.1*µ*m by injecting the evaporated Mo ions on the surface of the base material through the FLAD method.

In addition, the N₂, which is a process gas, was injected into the reaction chamber 100 to react with the Mo ions evaporated from the Mo target to coat the MoN support layer 20 in a thickness of 0.5*µ*m(non-ionic Mo particles were collected by the electromagnetic filter).

Thereafter, the carbonization gas and the HMDSO gas were injected into the reaction chamber to form the SiO-DLC functional layer 40.

### Comparative Example 1

Unlike the Embodiment according to the present disclosure, the Comparative Example 1 is characterized in that the coating material is not formed on the base material of the ball and the valve seat. The base material of the ball and the valve seat is made of SUS400C stainless iron as in the Embodiment.

### Comparative Example 2

A coating material having the same thickness was formed on the same SUS400C stainless base material of the ball and the valve seat as in the Embodiment, but by using Cr instead of Mo, a Cr bonding layer was formed on the surface of the base material of the ball and the valve seat, and a CrN support layer was formed on the outer circumferential surface of the Cr bonding layer, and then the SiO-DLC functional layer was formed on the surface of the CrN support layer through the method of injecting the HMDSO gas while injecting the carbonization gas into the reaction chamber 100.

### Comparative Example 3

A coating material including the Mo bonding layer, the MoN support layer, and the SiO-DLC functional layer was stacked on the SUS400C stainless base material of the ball and the valve seat as in the Embodiment of the present disclosure, but unlike the Embodiment of the present disclosure, the Mo bonding layer and the MoN support layer were deposited through the existing general physical vapor deposition (PVD) (a separate filter was not applied).

### Durability performance evaluation experiment

In order to conduct durability performance evaluation, a Dry-run test was conducted. The corresponding durability test was an experiment for evaluating the durability of each coating material during a short time, and was conducted equally under the following test conditions for the Embodiment and Comparative Examples 1 to 3.

The test gas was air or nitrogen, the supply pressure was 5bar, the test temperature was conducted at room temperature, a Peak & Hold (PHID, 1.2A & 0.6A current control method) was used as a driver stage, the supply voltage was 14.0V, the pulse period was 5.0ms, the pulse width was 2.5ms, and the operating time was 30 minutes or more.

As a determination criterion, whether there was any damage such as peeling of the coating material surface was visually confirmed, and the coating thickness was evaluated.

The average value of the coating thicknesses of two places of 0° and 180° of the product and the thickness difference of the coating materials of two places were measured. The thickness was measured by using a carotester.

**Table 1**

| Items | Embodiment | Comparative Example 1 | Comparative Example 2 | Comparative Example 3 |
|---|---|---|---|---|
| | Mo/MoN/ SiO-DLC | SUS440C (no coating) | Cr/CrN/ SiO-DLC | Mo/MoN/ SiO-DLC |
| Thickness (*µ*m) | 2.0 | - | 2.0 | 2.0 |
| Coating time | < 6h | - | < 6h | < 6h |
| Coating process | FLAD & PACVD | - | PVD & PACVD | PVD & PACVD |
| Durability performance evaluation results test) | (Dry-run thickness: 5% loss visually: no abrasion mark | abrasion mark (large) | thickness: 27% loss visually: abrasion mark found | thickness: 19% loss visually: abrasion mark found |

According to Table 1, as the result of the durability performance test, it was confirmed that the ball and the valve seat to which the coating material according to the Embodiment of the present disclosure was applied lost 5% in the thickness of the coating material, and had no abrasion mark.

On the other hand, it was confirmed in Comparative Example 2 that the thickness of the coating material was lost by 27%, and the abrasion mark was slightly found.

In addition, it was confirmed in Comparative Example 3 that the thickness of the coating material was lost by 19%, and the abrasion mark was slightly found.

As a result, as the result of testing the durability performance on the coating material of the ball and the valve seat, it was confirmed that the Embodiment of the present disclosure had a very low loss rate of the coating material as compared to the Comparative Examples, thereby having a very good durability performance.

### Physical property evaluation

In order to evaluate the physical property of the coating material, the physical property evaluation was conducted.

A Plate on disk experiment was conducted by using 10N, 0.1m/s, 2km, and SUS400C pins in order to derive the friction coefficient.

A micro indenter (0.05N, 0.7*µ*m indenting depth) was used for measuring the hardness.

A scratch tester and a rockwell C tester (HF1: high bonding force, HF5: low bonding force) were used for measuring the bonding force.

**Table 2**

| Items | Embodiment | Comparative Example 1 | Comparative Example 2 | Comparative Example 3 |
|---|---|---|---|---|
| | Mo/MoN/ SiO-DLC | SUS440C (no coating) | Cr/CrN/ SiO-DLC | Mo/MoN/ SiO-DLC |
| Hardness (HV) | 2337 (24.09 GPa) | 772 (7.32 GPa) | 2173 (30.63 GPa) | 2281 (21.66 GPa) |
| Heat resistance temperature | 400°C | - | 400°C | 400°C |
| Roughness Ra (*µ*m) | 0.027 | 0.2 | 0.043 | 0.04 |
| Frictional coefficient Dry | 0.06 | 0.45 | 0.13 | 0.11 |
| Friction coefficient oil | 0.03 | 0.22 | 0.06 | 0.05 |
| Adhesive force | HF 137 N | - | HF 1-231 N | HF 1-233 N |

As illustrated in Table 2 above,
It was confirmed that the Embodiment of the present disclosure was measured to have a good hardness value and a relatively low friction coefficient, thereby reducing the friction resistance as compared to the Comparative Examples.

In addition, the adhesive force of the coating material according to the Embodiment of the present disclosure was 37N and was evaluated to be superior to the adhesive forces of other Comparative Examples, particularly, the adhesive force 33N of Comparative Example 3, which was analyzed because the surface roughness of the Embodiment deposited according to the FLAD method of the present application could be kept very low.

## Claims

1. A ball and a valve seat for a fuel injector,
as the ball and the valve seat for the fuel injector on which a coating material having a multilayer structure is stacked on the surface of a base material,
wherein the coating material comprises
a Mo bonding layer stacked on the surface of the base material;
a MoN support layer stacked on the outer surface of the Mo bonding layer; and
a SiO-DLC functional layer stacked on the outer surface of the MoN support layer, and
wherein the Mo bonding layer and the MoN support layer are stacked by a physical vapor deposition method, and the SiO-DLC functional layer is stacked by a chemical vapor deposition method.

2. The ball and the valve seat for the fuel injector of claim 1,
wherein the Mo bonding layer is formed by radiating a laser to a Mo target in a vacuum atmosphere to cause an arc and depositing evaporated Mo ions on the base material.

3. The ball and the valve seat for the fuel injector of claim 2,
wherein the MoN support layer is formed by depositing MoN particles, which are formed by reacting Mo ions separated from the Mo target through the laser radiation with N ions separated from N2 gas injected as an activated gas, on the outer surface of the Mo bonding layer in a state where the Mo bonding layer is completely stacked.

4. The ball and the valve seat for the fuel injector of claim 3,
wherein non-ionic particles in addition to the Mo ions are generated by radiating the laser to the Mo target, and
wherein the non-ionic particles are collected through an electromagnetic filter, thereby preventing the non-ionic particles from being stacked on the base material or the Mo bonding layer.

5. The ball and the valve seat for the fuel injector of claim 1,
wherein the chemical vapor deposition method comprises a PACVD method using carbonization gas and Hexamethyl Disiloxane (HMDSO) gas.

6. The ball and the valve seat for the fuel injector of claim 1,
wherein before the Mo bonding layer is stacked, Ar ions in a plasma state are collided with the surface of the base material, thereby cleaning the surface of the base material.

7. A coating method of a ball and a valve seat for a fuel injector, the coating method comprising:
as the coating method of stacking a coating material having a multilayer structure on the surface of a base material of the ball and the valve seat for the fuel injector,
forming a Mo bonding layer which stacks a Mo bonding layer on the outer circumferential surface of the base material by a physical vapor deposition method;
forming a MoN support layer which stacks a MoN support layer on the outer surface of the Mo bonding layer by a physical vapor deposition method; and
forming a SiO-DLC functional layer which stacks a SiO-DLC functional layer on the outer surface of the MoN support layer by a chemical vapor deposition layer.

8. The coating method of claim 7,
wherein the forming of the Mo bonding layer comprises
generating Mo ions which generates evaporated Mo ions by radiating a laser to a Mo target in a vacuum atmosphere to cause an arc;
transporting the Mo ions which transports the Mo ions to the surface of the base material; and
depositing the Mo ions which deposits the transported Mo ions on the surface of the base material.

9. The coating method of claim 8,
wherein the forming of the MoN support layer comprises
forming MoN particles which forms MoN particles by reacting the Mo ions separated from the Mo target through the laser radiation with N ions separated from N2 gas injected as an activated gas in a state where the Mo bonding layer is completely stacked; and
depositing the MoN particles which deposits the MoN particles on the outer surface of the Mo bonding layer.

10. The coating method of claim 9,
wherein non-ionic particles in addition to the Mo ions are generated in the generating of the Mo ions, and
wherein the non-ionic particles are collected through an electromagnetic filter, thereby preventing the non-ionic particles from being stacked on the base material or the Mo bonding layer.

11. The coating method of claim 7,
wherein the chemical vapor deposition method comprises a PACVD method using carbonization gas and Hexamethyl Disiloxane (HMDSO) gas.

12. The coating method of claim 7, further comprising:
forming vacuum which maintains the internal atmosphere of the reaction chamber as a vacuum state, in a state where the ball and the valve seat are disposed inside a reaction chamber;
forming plasma which forms a plasma state where Ar ions are generated by injecting Ar gas into the reaction chamber and increasing the temperature of the reaction chamber; and
cleaning the surface of the base material by colliding the Ar ions with the surface of the base material of the ball and the valve seat.
